# EUROPEAN PATENT SPECIFICATION

(11) **EP 0 492 677 B1**
(45) Date of publication and mention of the grant of the patent: **12.06.1996**
(21) Application number: 91202756.2
(22) Date of filing: 24.10.1991
(51) Int. Cl.: G01R 31/307, G01R 31/311

(54) **Pulsed laser photoemission electron-beam probe**
Photoemissionselektronenstrahlmesssonde mit gepulstem Laser
Sonde à rayon d'électrons et à photo-émission pulsée par laser

(30) Priority: 28.11.1990 US 619927
(43) Date of publication of application: 01.07.1992
(73) Proprietor: SCHLUMBERGER TECHNOLOGIES, INC., San Jose, CA 95115 (US)
(72) Inventor: Richardson, Neil, Palo Alto, California 94301 (US); Wilsher, Kenneth R., Palo Alto, California 94301 (US)
(74) Representative: Smith, Keith

(56) References cited:
- EP-A- 0 348 785
- EP-A- 0 357 440
- WO-A-90/02955
- MICROELECTRONIC ENGINEERING. vol. 9, no. 1-4, May 1989, AMSTERDAM NL pages 405
- - 410; M.BRUNNER ET AL.: 'Non-Invasive Waveform Measurements of IC-Internal GHz Signals in a ps Time Scale'
- MICROELECTRONIC ENGINEERING. vol. 12, no. 1/4, May 1990, AMSTERDAM NL pages 279 - 286; R.SCHMITT ET AL.: 'Applications of High-Speed Electron-Beam Testing in Solid State Electronics'
- IBM JOURNAL OF RESEARCH AND DEVELOPMENT. vol. 34, no. 2/3, March 1990, NEW YORK US pages 204 - 214; P.MAY ET AL.: 'Picosecond photoelectron microscope for high-speed testing of integrated circuits'
- IEEE JOURNAL OF QUANTUM ELECTRONICS. vol. 24, no. 2, February 1988, NEW YORK US pages 198 - 220; K.J.WEINGARTEN ET AL.: 'Picosecond Optical Sampling of GaAs Integrated Circuits'
- MICROELECTRONIC ENGINEERING, vol. 12, nos. 1-4, May 1990, pages 213-220
- EXTENDED ABSTRACTS, vol. 88-2, The Electrochemical Society, Fall Meeting 1988, pages 559-561
- J. Vac. Sci. Technol. B6(6), November/December 1988, pages 2005-2008

## Description

### BACKGROUND OF THE INVENTION

### 1. Field of the Invention

The present invention relates to electron-beam probing methods and systems useful, for example, in analyzing operation of Very Large Scale Integrated (VLSI) circuit devices. In particular, the present invention relates to electron-beam probing methods and systems in which test patterns generated to exercise a device are synchronized with pulsed-laser photoemission of an electron probe beam.

### 2. The Prior Art

Characterizing and verifying the operation of VLSI circuit devices is an important element of their design. Probing internal nodes of such devices plays an increasingly significant role in this process.

The recent development of electron-beam (E-beam) probe tools and techniques has greatly assisted in overcoming the problems involved in probing internal nodes of integrated circuits. E-beam probing uses the principle of voltage contrast in a scanning electron microscope (SEM) to perform VLSI diagnosis through non-contact electron-beam measurement of internal signals in a VLSI device. A focused beam of primary electrons is directed toward a conductor within a circuit specimen as signals are applied to the specimen. Detected secondary electrons are indicative of the surface electrical potential on conductors within the specimen. See, for example, E. Menzel & E. Kubalek, *Fundamentals of Electron Beam Testing of Integrated Circuits,* 5 SCANNING 103-122 (1983), and E. Plies & J. Otto, *Voltage Measurement Inside Integrated Circuit Using Mechanical and Electron Probes,* IV SCANNING ELECTRON MICROSCOPY 1491-1500 (1985).

Commercial introduction by Schlumberger in 1987 of the "IDS 5000™" workstation-based, electron-beam test probe system greatly simplified E-beam probing of circuit chips and increased the efficiency of circuit debug. See S. Concina, G. Liu, L. Lattanzi, S. Reyfman & N. Richardson, *Software Integration in a Workstation Based E-Beam Tester,* INTERNATIONAL TEST CONFERENCE PROCEEDINGS (1986); N. Richardson, *E-Beam Probing for VLSI Circuit Debug,* VLSI SYSTEMS DESIGN (1987); S. Concina & N. Richardson *IDS 5000: an Integrated Diagnosis System for VLSI*, 7 MICROELECTRONIC ENGINEERING (1987); and see U.S. Patents 4,706,019 and 4,721,909 to N. Richardson. See also J. FROSIEN, *et al., High Performance Electron Optical Column for Testing ICs with Submicrometer Design Rules,* MICROELECTRON. ENG. (NETHERLANDS), vol. 7., no. 2-4, pp. 163-72 (First European Conference on Electron and Optical Beam Testing of Integrated Circuits, Grenoble, France, 9-11 December 1987).

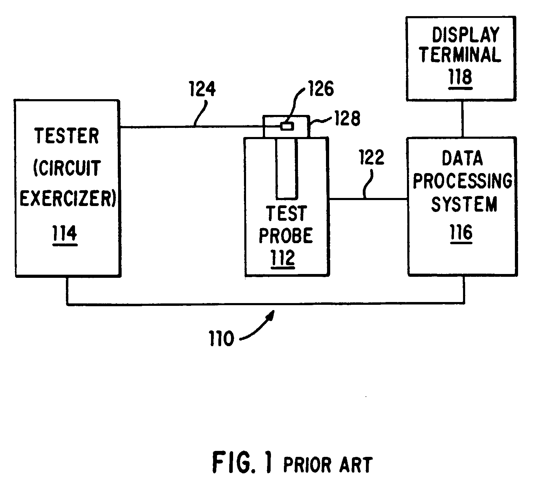

Figure 1 is a block diagram of a prior art electron-beam test probe system 110. The system has three main functional elements: an electron-beam test probe 112, a circuit exerciser 114, and a data processing system 116 which includes a display terminal 118. The circuit exerciser 114 may be a conventional integrated circuit tester, such as a model "S 15™" tester available from Schlumberger Technologies of San Jose, California, which can repeatedly apply a pattern of test vectors to the specimen circuit over a bus 124. The specimen circuit (device under test, or DUT) 126 is placed in a vacuum chamber 128 of the electron-beam test probe 112 so that potential measurements can be made as the test vector pattern is applied. The points at which such measurements are to be made are sent to the electron-beam test probe 112 by the data processing system 116 over a bus 122. The data processing system 116 may also be used to specify the test signal pattern used and the timing of the potential measurements relative to the test signal pattern. The electron-beam test probe system is controlled by an operator who inputs commands through the display terminal 118.

SEMs used for electron-beam probing, such as that in the IDS 5000 system, are equipped with high-speed beam pulsing hardware sometimes referred to as a "beam-blanker." An example of such hardware is described in U.S. Patent 4,721,909. Directing a pulsed electron beam at a particular node of interest provides a mode of operation much like that of a sampling oscilloscope, in which images can be produced of waveforms at one or more nodes in the specimen circuit as test vector patterns are applied to the specimen circuit.

For each point of the waveform image, a measurement is made by pulsing the electron beam at a specific time during application of the test vector pattern to the specimen circuit. Since the time needed to make a potential measurement is generally longer than the time over which the test signal pattern remains constant, stroboscopic techniques are used. That is, the electron beam is turned on for a brief period of time at a point in the test signal pattern. Each time the electron beam is so pulsed, a measurement of the potential on a node of the specimen circuit is made.

Since a single measurement has insufficient statistical accuracy to allow an accurate determination of the potential, measurements made over many repetitions of the test vector pattern are averaged. For even a relatively simple circuit under test, tens of thousands or even hundreds of thousands of repetitions of the test vector pattern may be needed to acquire the data represented in a waveform image. Coordination of the electron-beam pulses with the test vector pattern may be effected by a trigger generator circuit of the electron-beam test probe system under control of data processing system 116.

New design and process technologies result in ever-faster VLSI circuit devices having internal elements with decreased switching transition times. Device characterization and verification thus become increasingly difficult. Conventional electron-beam probe systems of the kind described above have at least two limitations which become critical as switching transition times of VLSI circuit devices decrease.

First, the electron source brightness obtained with the conventionally-used tungsten or lanthanum hexaboride thermionic emitters is low; at the necessarily low beam accelerating voltage of around 1 kV, the amount of peak current in the final electron probe is limited to about 1 nA when the probe diameter is around 0.1 micron. When the beam is pulsed with a duration of less than 50 ps (picoseconds) in order to perform high speed sampling measurements, the statistical average number of electrons per pulse is less than one. This leads to intractable signal processing problems and intolerably long signal integration times. For example, as the duty cycle (the trigger period divided by the beam pulse width) increases, leakage currents and other measurement limitations result in degraded measurement accuracy. Data acquisition time is a real concern, particularly with the lengthy test vector patterns require to exercise ever more complex integrated circuits.

Second, and because of the relatively low beam accelerating voltage, the construction of an effective beam pulser/blanker to produce pulses of duration much less than 50 ps is extremely difficult, and may be a practical impossibility in a commercial machine. Thus, even with a brighter source than those mentioned above, routinely generating pulses of less than 50 ps would still be difficult. Though brighter sources such as thermal field emitters are known (see, for example, L. SWANSON, *A Comparison of Schottky and Cold Field Emission Cathodes, .............* (FEI Company, Beaverton, Oregon, January 1989), they are not routinely used because of the extremely stringent requirements on the operating vacuum pressure around the source.

Work done at the IBM Watson Research Center, Yorktown Heights, New York, shows that it is possible, with a laser stimulated photocathode, to extend the performance of an electron beam prober to the point where beam pulses can be generated which are of less than 2 ps duration and which have more than 2000 electrons per pulse. See, for example, P. MAY, *et al, Picosecond photoelectron scanning electron microscope for noncontact testing of integrated circuits,* APPL. PHYS. LETT. 51 (2), pp. 145-147 (1987); P. MAY, *et al, Noncontact High Speed Waveform Measurements with the Picosecond Photoelectron Scanning Electron Microscope,* IEEE J. QUANTUM ELECTRON. (USA), Vol 24., No. 2, pp. 234-239 (February 1988); J-M. HALBOUT, *et al, SRAM Access Measurements Using a Picosecond Photoelectron Scanning Electron Microscope,* Paper No. WPM 8.2, International Solid State Circuits Conference (ISSCC, 1988); P. MAY, *et al., Waveform Measurements in High Speed Silicon Bipolar Circuits Using a Picosecond Photoelectron Scanning Electron Microscope,* International Electron Devices Meeting (IEDM, 1987).

While a pulsed-laser photoemission source offers a dramatically brighter source of short-duration electron-beam pulses (on the order of 10¹ electrons per pulse *vs.* 10⁻² electrons per pulse with typical thermionic sources), the pulsed-laser electron-beam cannot be readily turned on and off in response to trigger pulses from the test pattern generator in the manner employed with thermionic sources. Nor can the phase of the pulsed-laser electron-beam be readily shifted with respect to a fixed time reference. Thus, matching the electron-beam pulses to the test pattern from the circuit exerciser by controlling the electron-beam source does not appear feasible with a pulsed-laser photoemission source.

See P. MAY *et al., Picosecond photoelectron microscope for high-speed testing of integrated circuits,* IBM JOURNAL OF RESEARCH AND DEVELOPMENT, vol. 34, no. 2/3, March/May 1990, pages 204-214, from which the preamble of Claim 1 has been derived, discloses a SEM having a pulsed laser/photocathode combination. Pulses from a mode-locked Nd:YAG laser are twice frequency-doubled to ultraviolet and focused onto a photocathode of gold film on a quartz substrate to produce electron probe pulses. Phase delay between the waveform to be measured and the probe electron pulse is generated by offset of the triggering frequency with respect to the probing frequency. The waveform on the DUT is triggered optically. In one example the waveform is a single pulse photoconductively launched on a transmission line. In other examples the waveform is a square-wave signal triggered by applying the laser to a photodiode. In each example, the phase variation is no more than one period of the probing frequency because it is generated by varying the path length of the optical trigger for the electrical waveform on the DUT.

See also EP-A-0 357 440, which discloses an electro-optic test system having as an optical sampling source a mode-locked laser which generates light pulses at a constant repetition rate. The light output is split. One beam is incident on a photodetector, the electronic signal output of which drives a counter. The counter output provides a phase reference signal for a time base frequency synthesizer. The counter output is also used as a timing signal for an optical pulse selector which gates the optical output pulses of the laser and passes only those optical pulses which are time coincident with the output pulses of the counter. Those optical pulses which pass become the optical sampling pulses for sampling a DUT.

A further problem is raised by the fact that switching times of elements within the device under test (DUT) can be below 10 ps, yet conventional techniques of connecting to the device do not allow signals with transition times much below 50 ps to be effectively coupled into or out of the device. In general, a complex component is made by interconnecting thousands of active elements together on a chip. What is of interest is the actual performance of elements internal to the device. The non-contact, high-bandwidth measurement technique of electron-beam probing allows detailed observation of the timing relationships of signals internal to the device.

In order to make the most accurate, low-jitter measurements, the bandwidth of the connection between the test pattern generator and the device must be as high as possible to minimize degradation of switching edge speeds. Even then, each device connection (e.g., bond wire, probe pin and even bond pad) represents an unknown, complex impedance between the stimulus source and the on-chip element. Exact knowledge of the waveforms at the output of the test pattern generator does not therefore guarantee knowledge of the waveforms inside the device at the element of interest.

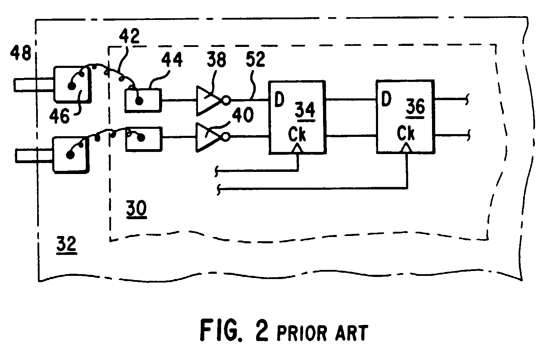

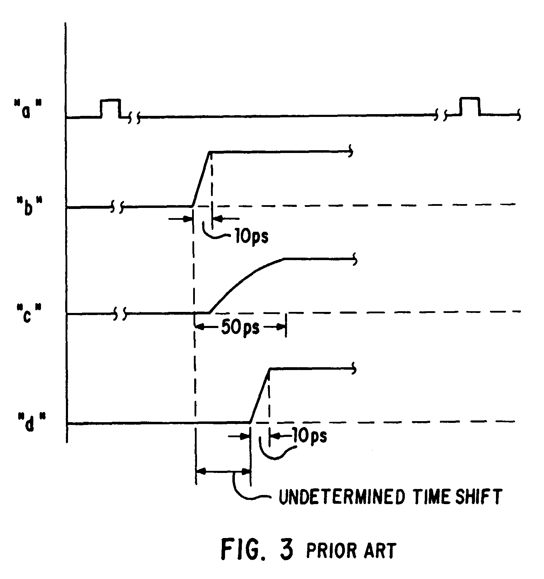

By way of illustration, Figure 2 shows schematically a portion of a VLSI circuit device 30 mounted on a carrier 32. Active elements forming part of device 30 include flip-flops 34 and 36 and inverters 38 and 40. Each of flip-flops 34 and 36 has a data input port D and a clock input port Ck. Bond wire 42 electrically connects bond pad 44 of device 30 to bond pad 46 of carrier 32. Bond pad 46 is in turn electrically connected to an input pin 48. Circuit exerciser 114 causes the electron-beam probe to be pulsed in stroboscopic fashion by sending trigger pulses (as shown in line "a" of Figure 3) to the test probe 112. Test patterns produced by circuit exerciser 114 are synchronized with these trigger pulses. While circuit exerciser 114 may be capable of generating a test pattern having a rising edge of, say, 10 ps duration as shown in line "b" of Figure 3, the impedance encountered over the path from input pin 48 to the active element 34 to be examined acts as a low-pass filter and introduces some indeterminate delay. That is, the rise time of the pulse at input port 50 of active element 38 may have a duration of, say, 50 ps as shown in line "c" of Figure 3. While on-chip element 38 may be able to restore the rise time of the pulse at input port 52 of element 34 to 10 ps as shown in line "d" of Figure 3, the intended placement of the rising edge is no longer assured.

### SUMMARY OF THE INVENTION

It is an object of the present invention to overcome many of the limitations of the prior art as outlined above. It is further an object of the present invention to offer a practical electron-beam probe system capable of making high-accuracy, low-jitter measurements of signals within circuit devices (such as ultra high-speed VLSI circuit devices) with the aid of a pulsed-laser photoemission electron-beam prober. These and other objects are attained with embodiments of the methods and apparatus of the present invention.

In accordance with a preferred embodiment of the invention, an electron-beam test probe system (400) is provided for analyzing an electronic circuit, the analysis including the measurement of the potential at selected points on the electronic circuit, the electron-beam test probe system comprising:
a. a test probe (402) having
   i. a photocathode (430, 804) for generating a train of electron beam pulses (1220) in response to a train of laser beam pulses,
   ii. means (426, 428) for applying electron beam pulses selected from said train of electron beam pulses to an electronic circuit, and
   iii. means (530) for measuring the potential at a point within the electronic circuit by detecting secondary electrons;
b. a laser subsystem (404) for generating a train of laser beam pulses having a stabilized repetition frequency (1214);
c. an optical coupler (452) for passing the train of laser beam pulses to the photocathode to generate the train of electron beam pulses;
d. a test pattern generator (416) responsive to a timebase circuit (412) for generating a formatted test pattern (1272) which is synchronized to the stabilized repetition frequency;
e. transmission lines (454) for supplying the formatted test pattern to the electronic circuit to be analyzed; and
f. a timebase circuit (412) synchronized with the laser subsystem and coupled to the test pattern generator (416) for inserting between a laser beam pulse of said train of laser beam pulses and the formatted test pattern a programmable delay,
characterized in that the length of the formatted test pattern and the length of the programmable delay are greater than one period of the stabilized repetition frequency and in that the timebase circuit (412) comprises:
i. a phase-locked voltage-controlled oscillator (910) synchronized with the laser subsystem (404), the oscillator supplying to the test pattern generator a reference clock signal (1210) having its phase dependent on a reference voltage supplied to the oscillator;
ii. means (906, 904) for supplying a programmable reference voltage to the oscillator to effect control of the phase of the reference clock signal; and
iii. a programmable counter (442) to count cycles of the reference clock signal supplied to the test pattern generator, said programmable counter providing a synchronization signal (1232) to said test pattern generator.

These and other features of the invention will become apparent to those of skill in the art from the following description of preferred embodiments of the invention and the accompanying drawing figures.

### BRIEF DESCRIPTION OF THE DRAWING

Figure 1 is a block diagram of a prior art electron-beam test probe system;
Figure 2 is a schematic diagram of a portion of a VLSI circuit device mounted on a carrier, as known in the prior art;
Figure 3 is a timing diagram illustrating a shortcoming of prior art methods of electron-beam probing of a VLSI circuit device of the type shown in Figure 2;
Figure 4 is a simplified schematic view of a system in accordance with the present invention;
Figure 5 is a schematic, sectional view of the test probe of Figure 4;
Figure 6 is a partial sectional view of the wafer probes and portions of the electron-beam column of Figure 4;
Figure 7 is a schematic plan view of the pulsed-laser subsystem of Figure 4;
Figure 8 is a cross-sectional view of a portion of the test probe of Figure 4;
Figure 9 is a schematic block diagram of the timebase circuit portion of Figure 4;
Figure 10 is a schematic block diagram of the timing generators circuit portion of the test pattern generator of Figure 4;
Figure 11 is a schematic block diagram of the formatters and pin drivers circuit portions of the test pattern generator of Figure 4;
Figures 12A and 12B are timing diagrams showing exemplary waveforms of the system in accordance with the invention; and
Figure 13 is a simplified illustration of how the invention may be employed in analyzing an electronic circuit.

### DESCRIPTION OF THE PREFERRED EMBODIMENTS

In accordance with the present invention, an electron beam is used not only as a high-bandwidth, guided probe for interactive waveform measurement but also as a tester (circuit exerciser) calibration probe. The test pattern applied to the external pins of the DUT can be adjusted (*e.g.,* time-shifted) while the actual signal at a port of an element of interest (*e.g.,* an active element such as a flip-flop on the DUT) is observed. In this way, test pattern edges may be placed with precision of a few picoseconds (ps) at each port of an element of interest, before further measurements are made within the DUT.

For this to be effective, it is necessary to achieve an exceptionally high measurement bandwidth. This may be done by adapting the technique described by IBM (mode-locked, laser-based photoemission for fast sampling pulse generation), which to date is believed to have been demonstrated only in a primitive form in the laboratory. The present invention is directed to implementation of a practical electron beam probing system with a time resolution on the order of 10 ps, together with a low-jitter, high-accuracy test pattern source with multiple output pins and flexible formatting capability.

In accordance with preferred embodiments of the present invention, the basic architecture of the Schlumberger IDS 5000 electron beam diagnostic system is retained to provide a convenient user interface and convenient access to the electronic circuit under test. Significant modifications made, however, are described below.

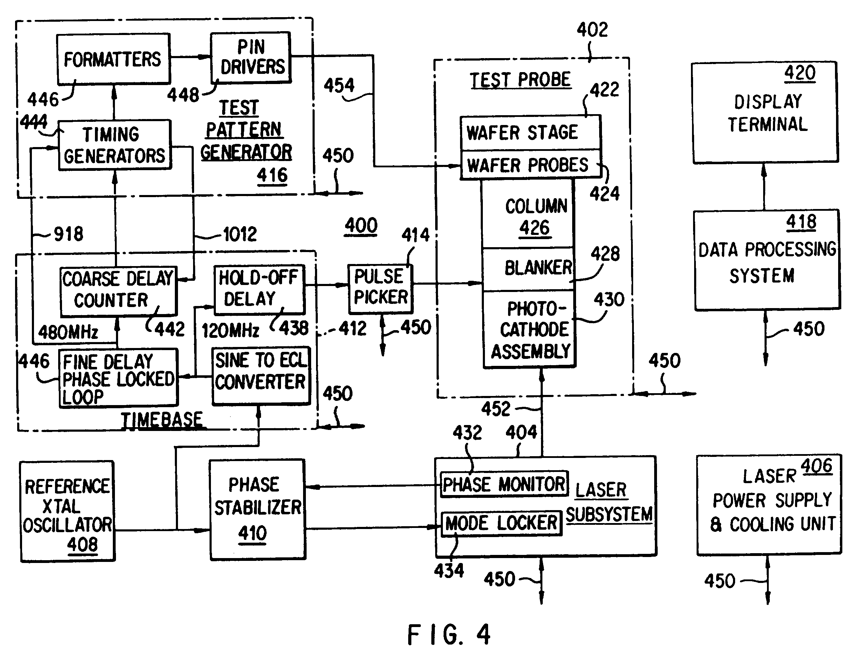

Figure 4 is a schematic block diagram of a preferred embodiment of an electron-beam system 400 in accordance with the present invention. System 400 comprises a test probe 402, a laser subsystem 404 with associated power supply and cooling unit 406, an optical coupler 452 (such as a light pipe or optical fiber), a reference oscillator 408, a phase stabilizer 410, a timebase circuit 412, a pulse-picker circuit 414, a test pattern generator 416, a set of controlled-impedance transmission lines 454, a data-processing system 418, and a display terminal 420.

Test probe 402 comprises a wafer stage 422 for holding and positioning a wafer bearing one or more IC devices to be probed, wafer probes 424, an electron-beam column 426, an electron-beam blanker 428 (*e.g.,* of the type described in U.S. Patent 4,721,909), and a photocathode assembly 430. Laser subsystem 404 includes a mode locker 434 and a phase monitor 432, among other elements which will be described below. Timebase circuit 412 comprises a sine-to-ECL converter 436, a hold-off delay 438, a fine-delay phase-locked loop 440, and a coarse delay counter 442. Test pattern generator circuit 416 comprises a set of timing generators 444, a set of formatters 446, and a set of pin drivers 448. Data processing system 418 communicates with each of the system elements via control and data lines 450 which may, for example, be in the form of one or more serial and/or parallel data buses.

In operation, reference oscillator 408 produces a 120 MHz sine wave reference signal which is supplied to phase stabilizer 410 and to timebase circuit 412. The use of a phase stabilizer is optional, and serves to reduce low-frequency phase noise in the output pulse stream (jitter). Phase stabilizer 410 in turn supplies a 120 MHz sine wave drive signal to mode locker 434 of laser subsystem 404. Phase monitor 432 provides a feedback signal to phase stabilizer 410 to assure stabilization of the output pulse train of laser subsystem 404. Laser subsystem 404 generates a train of ultraviolet (UV) wavelength laser pulses at a repetition frequency of 240 MHz, the laser pulses being conveyed via an optical coupler (light pipe or optical fiber) 452 to photocathode assembly 430 of test probe 402. Photocathode assembly 402 produces an electron-beam pulse in response to each laser pulse arriving through light pipe or optical fiber 452. The electron-beam pulses may be directed to "probe" the DUT and supply signals to data processing system 418 which may be used to display measured parameters of the DUT on display terminal 420.

Timebase circuit 412 serves to synchronize the test pattern applied to a DUT (mounted in test probe 402) with electron-beam pulses applied to the DUT. Electron-beam pulses to be applied to the DUT are selected by unblanking of the electron-beam pulse train under control of pulse picker 414 and hold-off delay 438, hold-off delay 438 being supplied with the 120 MHz reference signal via sine-to-ECL converter 436. A test pattern to be applied to the DUT may be controllably time-shifted relative to the electron-beam pulse train by means of the fine-delay phase-locked loop 440 and coarse-delay counter 442. A desired pattern of test vectors to be applied to the DUT is generated by means of timing generators 444 and formatters 446, and supplied to the DUT via pin drivers 448, controlled-impedance transmission lines 454, and wafer probes 424. As the DUT is exercised by the applied test vector pattern, the test-vector pattern may be time-shifted relative to the laser/e-beam pulses by control of timebase circuit 412. The time shift imposed by timebase circuit 412 is controlled by data processing system 418 via control and data lines 450. Test pattern edges at conductors of interest within the DUT may thus be controllably time-positioned relative to the electron-beam probe pulses applied to those conductors.

### Electron Beam Probe 402

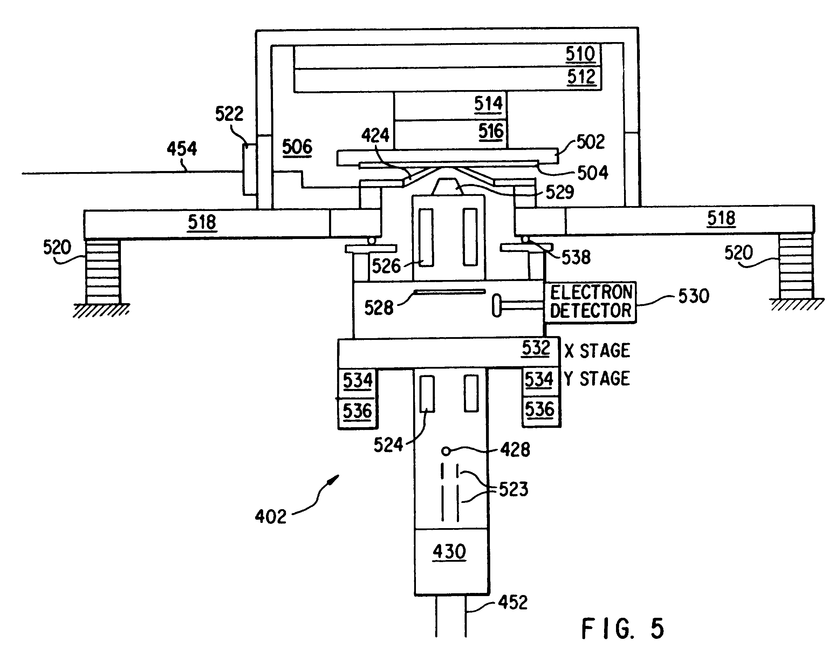

Figure 5 is a schematic, sectional view of the test probe of Figure 4. Wafer stage 422 comprises a chuck 502 for holding a wafer 504 within a vacuum chamber 506, and an X stage 510, a Y stage 512, a Z stage 514 and a Theta stage 516 for positioning chuck 502 and wafer 504 relative to wafer probes 424. Such a positioning stage is described in U.S. Patent No. 4,706,019 and provided, for example, in the commercially-available Schlumberger IDS 5000 system. Wafer stage 422 is mounted on a base plate 518 which is supported on vibration isolators 520. A hermetic feedthrough 522 is provided for passing signals via transmission lines 454 to wafer 504 via wafer probes 424. Electron-beam column 426 comprises an electrostatic lens assembly 523, a condenser lens 524, an objective lens 526, an energy analyzer electrode 528, an extractor electrode 529, an electron detector 530, an X stage 532 and a Y stage 534 mounted on supports 536. A sliding vacuum seal 538 allows electron-beam column 426 to be moved relative to wafer 504 by means of X,Y stages 532 and 534 without loss of vacuum in chamber 506. For simplicity, well-known elements of the test probe are not illustrated in Figure 5, such as control and signal and power lines to and from the stages, lenses and electron detector.

In operation, the circuit device under test (*e.g.,* on wafer 504) is placed in vacuum chamber 506, which is evacuated by means of a pump (not illustrated). If the circuit device is packaged, an adapter comprising a printed circuit board and device socket are used to connect the pins of the DUT to incoming test patterns from the circuit exerciser, in conventional fashion. In the case where the DUT is on a wafer 504 as shown in Figure 5, high-bandwidth co-planar waveguide wafer probe pins may be used to deliver the incoming test patterns (*e.g.,* WPH 700 series, available from Cascade Microtech, of Beaverton, Oregon). The standard Cascade Microtech probe has mode suppressing material extending over the ceramic blade of the probe which may interfere with the support of energy analyzer extraction electrode 528 of electron-beam column 426. Cascade Microtech confirms that this piece of the mode suppressor can be removed if necessary (for example, by machining). Transmission lines 454 may be individual coaxial cables or may be microstrip fabricated by depositing copper traces on a flexible substrate such as polyimide. Microstrip transmission lines are also available from Cascade Microtech.

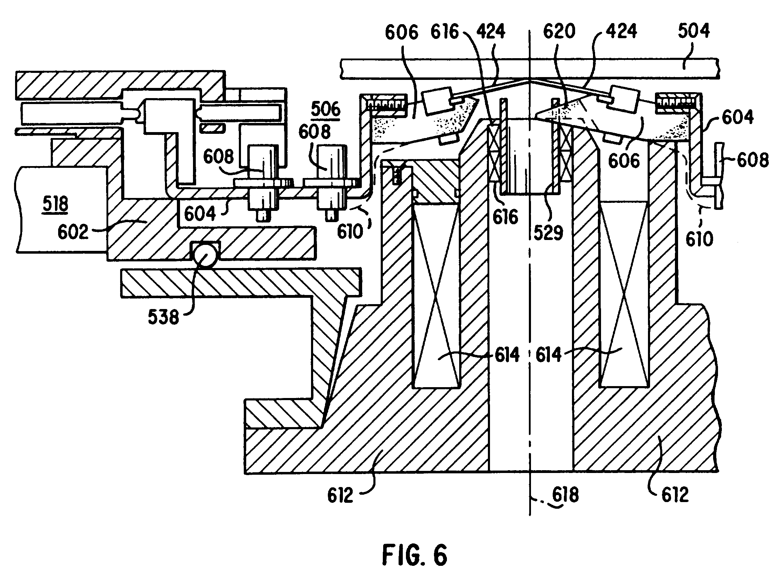

Figure 6 is a partial, sectional, schematic view showing in greater detail the wafer probes and portions of the electron-beam column of Figure 4. Mounted on base plate 518 is a support member 602, into which is fitted a probe carrier 604. Wafer probes 424 are mounted on mode suppressors 606 (of a lossy, ferrite material), which are in turn mounted on probe carrier 604. Adjusting screws (not shown) facilitate alignment of the wafer probe tips in the plane of a wafer 504 to be probed. Signals from pin drivers 448 are conveyed to wafer probes 424 by coaxial cables (not shown) via SMA-type connectors 608 and flexible microstrip transmission lines 610 (shown as dashed lines). The upper end of column 426 includes an objective lens body 612, an objective lens coil 614, extractor electrode 529 (which may include a mesh, not shown), and deflection coils 616 (for scanning and/or vectoring the electron beam). The electron-optical axis of the body 612 is indicated by dashed line 618.

Body 612 is laterally movable relative to base plate 518 and support member 602 by means of stages 532 and 534, for aiming the electron-beam probe at a desired location on wafer 504. Seal 538 allows such movement without loss of vacuum in chamber 506. Shown at the left side of axis 612 is a mode suppressor 606 which has been modified to allow room for the upper end of body 612 and electrode 529. Shown at the right side of axis 612 is a mode suppressor 606 which has not been so modified; phantom lines indicate the region of where mode suppressor end portion 620 may interfere with body 612 and electrode 529. It is the end portion 620 which is preferably removed (as mentioned above) to avoid such interference.

### Laser Sub-System 404

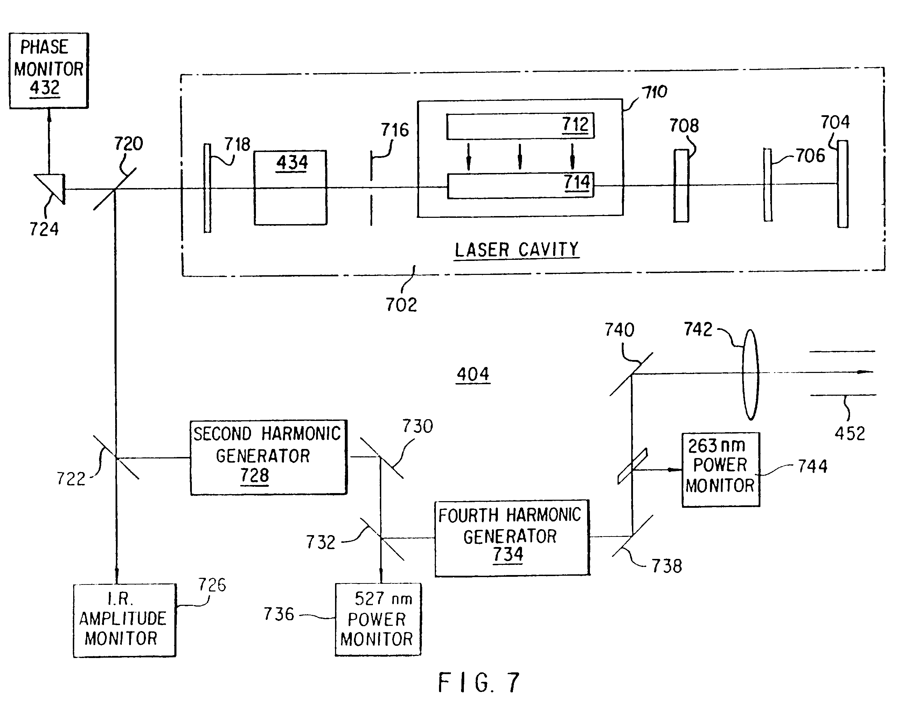

The layout of pulsed-laser sub-system 404 of Figure 4 is shown in schematic plan view in Figure 7. In a first (laser cavity) stage 702, a flash-lamp-pumped, short-cavity, mode-locked, Neodymium-YLF (Yttrium-Lithium-Fluoride) laser produces pulses of 25 ps duration, about 4W average power, at 1053 nm in the infra-red (IR) frequency range. The first stage comprises a high-resolution mirror assembly 704, a cavity length adjuster 706, an intra-cavity shutter 708, a laser head 710 having a pump lamp 712 and a laser medium 714, an aperture 716, mode locker 434, and an output mirror 718.

Beam turning mirrors 720 and 722 pass the pulsed IR laser beam to the second stage, and allow the beam to be sampled by phase monitor 432 via a right-angle prism 724 and by an IR amplitude monitor 726. A feedback signal output from phase monitor 432 is supplied to phase stabilizer 410 as shown in Figure 4.

The second stage of laser subsystem 404 comprises a second-harmonic generator 728 which preferably includes a KTP (potassium titanyl phosphate) frequency-doubler crystal which converts the incoming IR pulses to shorter duration pulses *(e.g.,* pulses of 25/√2 ps duration) in the green part of the spectrum *(e.g.,* at 527 nm wavelength) at much lower power (*e.g.,* a few hundred milliwatts). The second stage further comprises beam-turning mirrors 730 and 732, the latter permitting sampling of the green laser pulses by a 527 nm power monitor 736.

The green output beam from the second stage is fed to a fourth-harmonic generator 734 of the third stage. Fourth-harmonic generator 734 includes a final doubler crystal (for example, of beta barium borate (BBO) or KDP crystals) which converts the green pulses from the second stage into pulses of about 12 ps duration at 263 nm in the ultra-violet (UV) range at still lower power (*e.g.,* a few milliwatts). The third stage further comprises beam-turning mirrors 738 and 740, and a 263 nm power monitor 744.

The final stage of the laser sub-system includes beam focusing optics 742 which pass the UV laser pulses to optical coupler 452. Optical coupler 452 is preferably a light pipe (*e.g.,* produced by Laser Mechanisms of Southfield, Michigan, and available through Quantronix Corporation of Smithtown, New York) comprising a flexible or articulated tube having knuckle joints fitted with mirrors to convey the pulsed UV beam to photocathode 430, though other suitable means such as a single-mode UV fiber or the like may be used.

The output of IR amplitude monitor 726 is used for internal regulation of laser subsystem 404, as are the outputs of power monitors 736 and 744. As is known in the art, the frequency doubler crystals of generators 728 and 734 must be temperature-controlled. The internal regulation means of laser subsystem 404 is not illustrated, for simplicity of description.

A flash-lamp-pumped, short-cavity, mode-locked, Neodymium-YLF laser of the type described is commercially available from Quantronix Corporation of Smithtown, New York, Model 498MLSHFH-240.

Those of skill in the art will recognize that the described laser subsystem provides a highly-stable source of narrow UV pulses (*e.g.,* having a pulse width on the order of 12 ps) at a repetition frequency of, for example, 240 MHz. Other suitable laser sources may be used, if desired. In the work done at IBM (referenced above), a long-cavity YAG laser was used, which gives fairly broad pulses on the order of 70 ps, and employs a fiber grating compressor. It requires that the beam be launched into a fiber, and tends to be difficult to handle. The flash-lamp-pumped, short-cavity, mode-locked, Neodymium-YLF laser described above with reference to Figure 7 is expected to be somewhat less performant (*e.g.,* 12 ps pulse width *vs.* 2 ps pulse width), but is preferred as it currently appears to offer the greater durability and stability desired for a commercial system.

Numerous other modifications to the laser subsystem are also possible. For example, it may be possible to mount harmonic generator 734 onto photocathode assembly 430, and to employ a flexible optical coupler to convey green laser light from generator 728 to generator 734. Similarly, it may be possible to mount harmonic generators 728 and 724 onto photocathode assembly 430, and to employ a flexible optical coupler to convey infrared laser light from first stage 702 to harmonic generator 728. Also, it is envisioned that pump flash-lamp 712 may be replaced with solid-state, infrared diodes. In this case, it may be possible to mount substantially all of the laser subsystem onto photocathode assembly 430, which is affixed to and moves with column 426.

### Photocathode Assembly 430

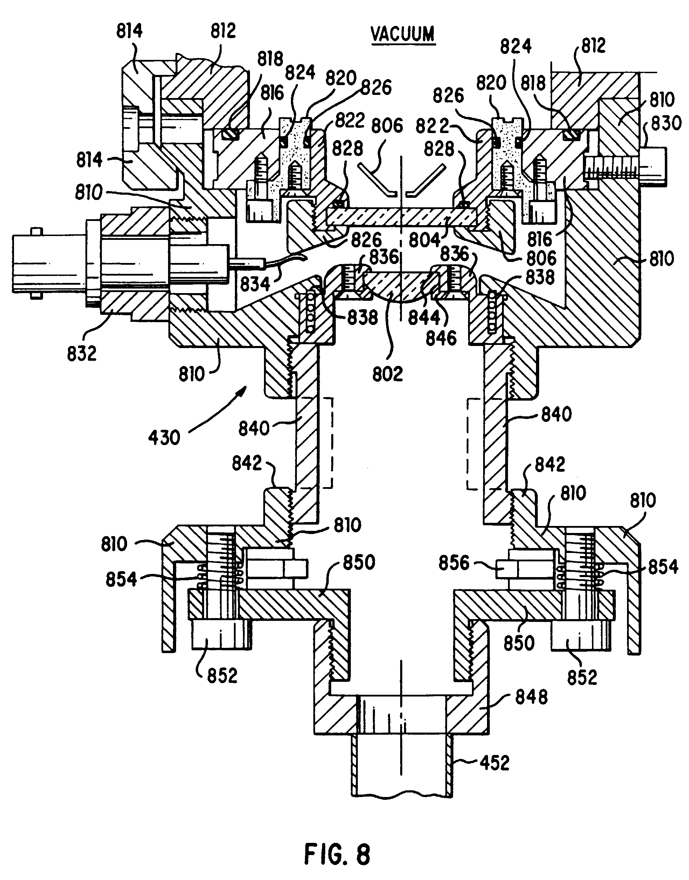

Figure 8 is a cross-sectional view of a portion of test probe 402 showing principal elements of photocathode assembly 430 and certain surrounding components. Ultraviolet laser pulses arriving via optical coupler 452 pass through a focusing lens 802 to a photocathode element 804 which produces an electron-beam pulse in response to each laser pulse. The electron-beam pulses pass through an aperture in an extractor anode 806 of electron-beam column 426. Anode 806 is preferably maintained at a relatively high positive voltage (*e.g.,* 3 kV - 4 kV) so as to accelerate the electrons sufficiently to avoid space-charge spreading of the electron-beam pulses. Photocathode element 804 preferably comprises a transparent, quartz disk of 3 mm thickness, optically polished on both faces to transmit UV laser light with minimum distortion, with a layer of calcium fluoride deposited on its upper surface and with a layer of gold deposited over the calcium fluoride layer.

Photocathode assembly 430 is preferably designed to replace the thermionic electron-beam gun of a conventional IDS 5000™ test probe system. As shown in Figure 8, a generally-cylindrical main body 810 mounts on the lower end 812 of electron-beam column 426, and is held in place by a clamp 814. Held between column lower end 812 and a shoulder of main body 810 is a conductive, photocathode carrier ring 816. O-ring 818 hermetically seals the junction between column lower end 812 and carrier ring 816. An insulator ring 820 mounts within carrier ring 816, and a conductive photocathode support ring 822 mounts within insulator ring 820. The junctions between carrier ring 816 and insulator ring 820, and between insulator ring 820 and support ring 822, are hermetically sealed by O-rings 824 and 826, respectively. Photocathode 804, which fits into support ring 822, is held in place by a conductive closure ring 826 which threads onto the lower end of support ring 822. An O-ring 828 hermetically seals the junction between photocathode 804 and support ring 822.

It can be seen that, due to the hermetically-sealed junctions, photocathode 804 serves as a lower vacuum boundary of electron-beam column 426. That is, the region above photocathode 804 is contiguous with the evacuated column 426 and chamber 506, and the region below photocathode 804 contains air at atmospheric pressure. One or more screws 830 threaded into main body 810 serve to laterally position carrier ring 816. The photocathode may be refreshed from time to time by turning screws 830 to laterally displace carrier ring 816. O-ring 818 slides relative to the lower surface of column lower end 812 without breaking the hermetic seal.

A connector 832 provides a cathode-voltage connection to closure ring 826 via a spring contact 834. The cathode voltage is applied to the gold surface of photocathode 804 via closure ring 826 and support ring 822. Main body 810 is maintained at a voltage of, for example, minus 1000 volts relative to ground.

A lens support ring 836 slidably disposed in a bore of main body 810 is resiliently biased downwardly by a spring 838 and retained by a focusing barrel 840. Focusing barrel 840 is threaded into the interior bore of main body 810, and may be manually rotated to adjust the vertical position of lens support ring 836 relative to main body 810. Cut out regions 842 of main body 810 allow access to barrel 840 for this purpose. Lens 802 is held against a shoulder 844 of lens support ring 836 by a retainer ring 846. Rotation of focusing barrel 840 allows the parallel laser beam arriving at lens 802 to be focused to a spot at photocathode 804 by axial adjustment of the position of lens 802.

Optical coupler 452 (*e.g.,* a light pipe) attaches by means of a screw coupler ring 848 to a flanged ring 850 which is in turn mounted within the lower bore of main body 810 by shoulder bolts 852. Compression springs 854 resiliently bias flange 850 away from main body 810 in the axial direction. A resilient seal 856 keeps dust and other contamination from entering the bore of main body 810. The laser beam entering via optical coupler 452 may be aligned with the central optical axis of main body 810 by tilting flange 850 through suitable adjustment of shoulder bolts 852.

### System Timebase Circuit 412

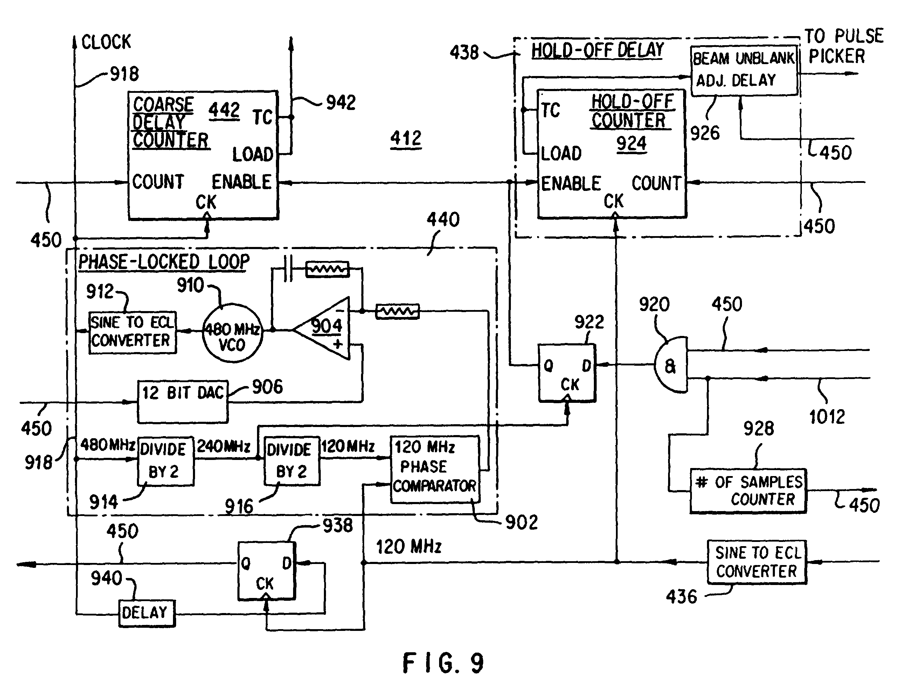

Figure 9 is a schematic block diagram of the timebase circuit portion of Figure 4, showing the four basic elements of timebase circuit 412 (sine-to-ECL converter 436, hold-off counter 438, fine-delay phase-locked loop 440, and coarse delay counter 442) as well as minor additional logic not shown in Figure 4.

Phase-locked loop 440 comprises a 120 MHz phase comparator 902, which receives a 120 MHz reference signal from oscillator 408 via sine-to-ECL converter 436. The output of comparator 902 is supplied to an integrator 904 whose threshold is set by time-base vernier data from data processing system 418 via data lines 450 and 12-bit digital-to-analog converter 906. A control voltage output from integrator 904 is provided to a 480 MHz voltage-controlled oscillator 910. The output of VCO 910 is supplied via a sine-to-ECL converter 912 to series-connected divide-by-two circuits 914 and 916. The output of divide-by-two circuit 916, a 120 MHz signal, is supplied to the second input of 120 MHz phase comparator 902. It will be seen that phase-locked loop 440 provides at its main output line 918 a 480 MHz clock signal which may be controllably phase-shifted in vernier fashion over a range of ± 180° by supplying appropriate time-base vernier data from data processing system 418 to 12-bit DAC 906 over data lines 450.

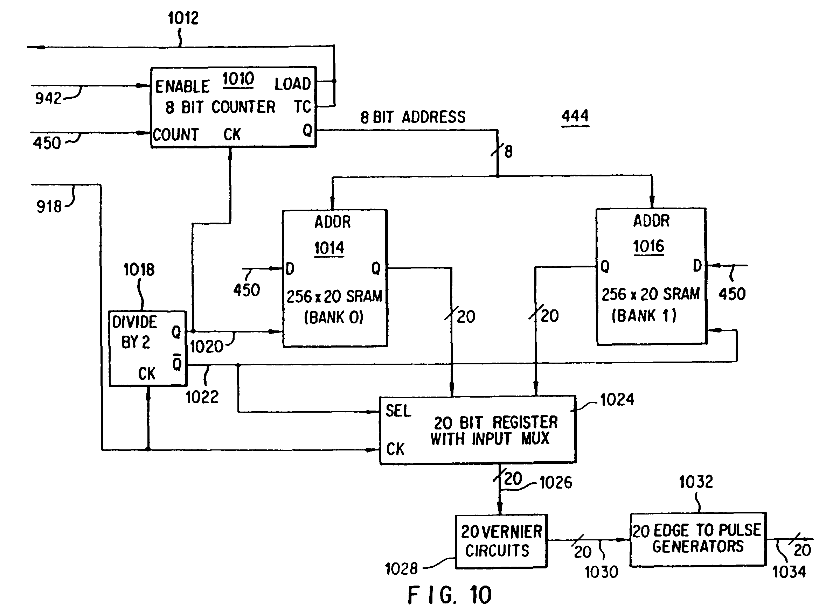

An AND gate 920 receives an asynchronous enable ("start" sequence) signal from data processing system 418 at a first input, and a "restart" signal from timing generators 444, as will be explained below. The output of AND gate 920 is synchronized with the 240 MHz output of divide-by-two circuit 914 in a flip-flop 922 to provide a "sync enable" signal to the enable input of coarse delay counter 442. The 480 MHz clock signal at output line 918 of phase-locked loop 440 is supplied to the clock input of coarse delay counter 442. The terminal count value of coarse delay counter 442 is set by timebase counter data from data processing system 418 via data lines 450. A number-of-samples counter 928 counts the restart pulses on line 1012 (from a counter 1010 shown in Figure 10), and the stored count value is monitored by data processing system 418.

When the async enable and restart signals supplied to AND gate 920 assume a logic high level, coarse delay counter 442 will begin counting in sync with the 480 MHz clock signal from phase-locked loop 480. When coarse delay counter 442 reaches its terminal count value, it provides a "sync enable delayed" output signal to timing generators 444 and to its own load input to reset itself for the next count cycle.

The sync enable signal from flip-flop 922 is also supplied to the enable input of a hold-off counter 924 of hold-off delay circuit 438. The 120 MHz reference signal from sine-to-ECL converter 436 is supplied to the clock input of hold-off counter 924. Hold-off counter 924 provides an output signal, at a predetermined number of 120 MHz clock cycles following receipt of the sync enable signal, to a beam unblank adjustable delay circuit 926. Beam unblank adjustable delay circuit is a vernier delay which allows the output from hold-off counter to be controllably adjusted over a range of ± ½ of one 120 MHz reference cycle. The output of beam unblank adjustable delay circuit 926 is supplied to pulse-picker circuit 414 (*e.g.* a monostable flip-flop) which briefly unblanks beam blanker 428. The collective delay period of hold-off counter 924 and beam unblank adjustable delay are controlled by data processing system 418.

A D-type flip-flop may be supplied at its D input with the 120 MHz reference signal from sine-to-ECL converter 436, and at its clock input with the 480 MHz signal from sine-to-ECL converter 912 (via a delay element 940), to provide a calibration output signal. The calibration output signal from flip-flop 938 is a status bit monitored by data processing system 418 on the system bus to indicate coincidence of a vernier-delayed edge of the 480 MHz clock signal on line 918 with an edge of the 120 MHz clock signal from sine-to-ECL converter 436. Vernier-shifting the 480 MHz clock signal through a full cycle of phase shift by modification of the fine-delay data to DAC 906 allows data processing system 418 to determine a vernier scaling factor of the 480 MHz clock signal relative to the 120 MHz clock signal.

### Test Pattern Generator 416

Figure 10 is a schematic block diagram of the timing generators circuit portion of the test pattern generator of Figure 4. An 8-bit self-resetting terminal counter / address generator 1010 receives the sync enable delayed signal from coarse delay counter 442 via line 942 at its count-enable input, and the 480/2 MHz clock signal via line 1020 at its clock input. The number of clock pulses per count cycle is preset by data processing system 418 via data lines 450. When triggered to do so by the sync enable delayed signal, counter/generator 1010 counts 480 MHz clock cycles until it reaches the preset terminal count, then issues a "restart" signal on output line 1012. The restart signal on line 1012 is supplied to AND gate 920 of timebase circuit 412.

Counter/generator 1010 supplies 8-bit addresses to the respective address inputs of 256x20 SRAM barks 1014 and 1016. SRAM Banks 1014 and 1016 are pre-loaded by data processing system 418 via data lines 450 with data patterns from which edge patterns are generated in response to clock signals. The 480 MHz clock signal from phase-locked loop 440 is divided in a divide-by-two circuit 1018 into two 240 MHz clock signals at Q and Q-bar output lines 1020 and 1022, respectively. The 240 MHz signals on lines 1020 and 1022, which are of opposing phase, are supplied to the respective clock inputs of SRAM banks 1014 and 1016. Thus, SRAM bank 1014 provides at its Q output a 20-bit pattern of timing edges on "even" clock cycles and SRAM bank 1016 provides at its Q output a 20-bit pattern of timing edges on "odd" clock cycles. A 20-bit register with input multiplexer 1024, multiplexes the timing edge patterns from SRAM banks 1014 and 1016 in sync with the clock signals on lines 918 and 1020 to supply a pattern of output signals on a 20-bit wide bus. The pattern may have from 1 to 20 timing edges per cycle of 8-bit counter/generator 1010, with each of those edges being synchronized with an edge of a 480 MHz clock pulse (multiple edges may transition on a single 480 MHz clock pulse, if desired). An array of vernier circuits 1028, under control of data processing system 418, allows each of the timing edges to be adjusted in vernier fashion. The vernier-adjusted timing edge pattern from vernier circuits 1028 is supplied via a 20-bit wide bus 1030 to an array of edge-to-pulse generators 1032 (*e.g.,* monostable flip-flops). A pattern of narrow output pulses is supplied by generators 1032 via a 20-bit wide bus 1034 to formatters 446, and is repeated once for each cycle of counter/generator 1010. Counter/generator is programmable to count to any desired terminal-count value, the terminal-count value determines the number of test vectors in the desired test-vector pattern.

As counter/generator 1010 counts, it addresses each location of SRAM banks 1014 and 1016 in turn. In each column of the SRAM banks (there are 20 columns in each bank) a single "one" would be written, and the rest of the entries would be "zeros." As the counter counts down, the corresponding SRAM output goes high when a location with a "one" is addressed. Thus, the SRAM banks allow the relative time within a range of 0 - 512 periods to be programmed.

Multiplexing the generation of edge patterns as in the circuit of Figure 10 has the advantage that lower-speed components may be used than would otherwise be the case. For example, SRAM banks 1014 and 1016 need only have a short enough access time to deal with a 240 MHz clock signal. It will be recognized that the pulse pattern may be generated by circuits other than that shown in Figure 10. For example, counter/generator 1010, SRAM banks 1014 and 1016 and register/mux 1024 may be replaced with an array of counters of sufficiently high speed to be driven by the 480 MHz clock, or SRAM banks 1014 and 1016 and register/mux 1024 may be replaced with a single, high-speed memory.

### Formatters 446 and Pin Drivers 448

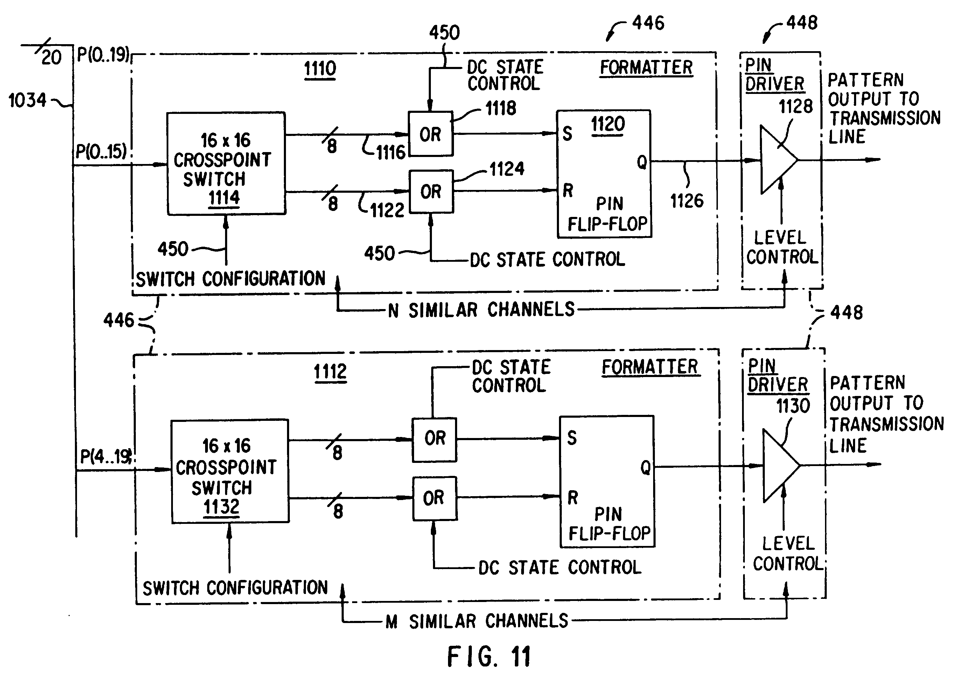

Figure 11 is a schematic block diagram of the formatters and pin drivers circuit portions of the test pattern generator of Figure 4. Any number of formatters 446 may be provided, with each formatter typically driving a single pin of the DUT. A formatter 1110 comprises a 16x16 crosspoint switch 1114 (*e.g.,* Gigabit Logic part number 10G051) which receives at its respective 16 signal inputs the pulse pattern from 16 of the 20 signal lines of bus 1034 (*e.g.,* signal line addresses 0:15 of bus 1034, as illustrated). Crosspoint switch 1114 may be configured by data processing system 418 via data lines 450. Pulses appearing on a first group 1116 of 8 output lines are supplied to the inputs of an OR gate array 1118 to drive the "set" input of set/reset flip-flop 1120. Pulses appearing on a second group 1122 of 8 output lines are supplied to the inputs of an OR gate array 1124 to drive the "reset" input of set/reset flip-flop circuit 1120. DC state control lines of OR gates 1118 are addressed by data processing system 418 to set the initial state of flip-flop 1120 (*e.g.,* at the beginning of a test-vector sequence). It will be seen that the pattern of up to 8 pulses appearing at Q-output line 1126 of formatter 1110 during each clock cycle is programmable at the will of the operator under control of data processing system 418. The pulse pattern appearing at line 1126 is passed to a pin driver circuit 1128 for driving a pin of the DUT. Any number N of channels similar to that formed by formatter 1110 and pin driver 1128 may be provided.

Likewise, any number M of channels similar to that formed by formatter 1112 and pin driver 1130 may be provided. Formatter 1112 is identical to formatter 1110, except that the input lines of 16x16 crosspoint switch 1132 receive the pulse pattern from a different group of 16 of the 20 signal lines of bus 1034 (*e.g.,* signal line addresses 4:19 of bus 1034, as illustrated). Thus, each formatter may use up to 16 of 20 pulses from the pattern on bus 1034 to form a pattern to drive a pin of the DUT, and any or all of those 16 pulses may be used in composing the pattern to drive a pin of the DUT.

### System Operation

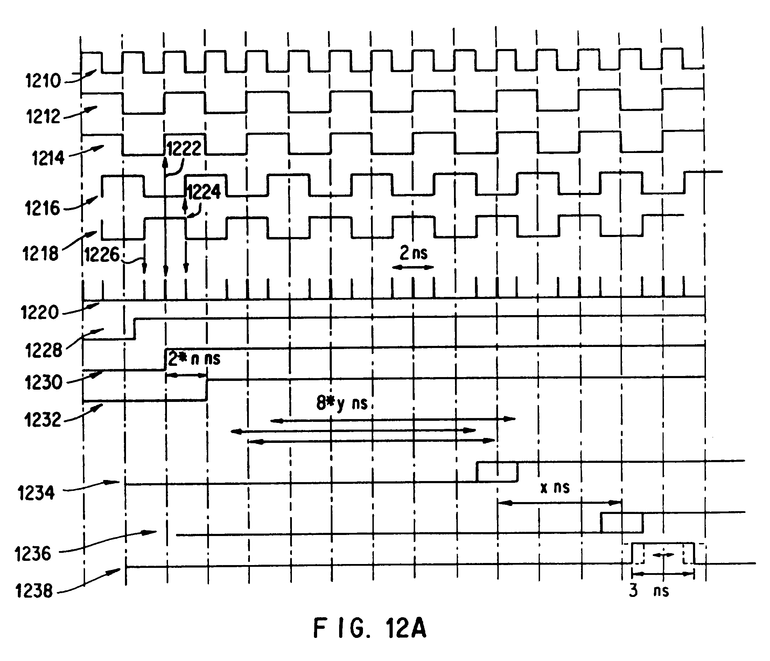

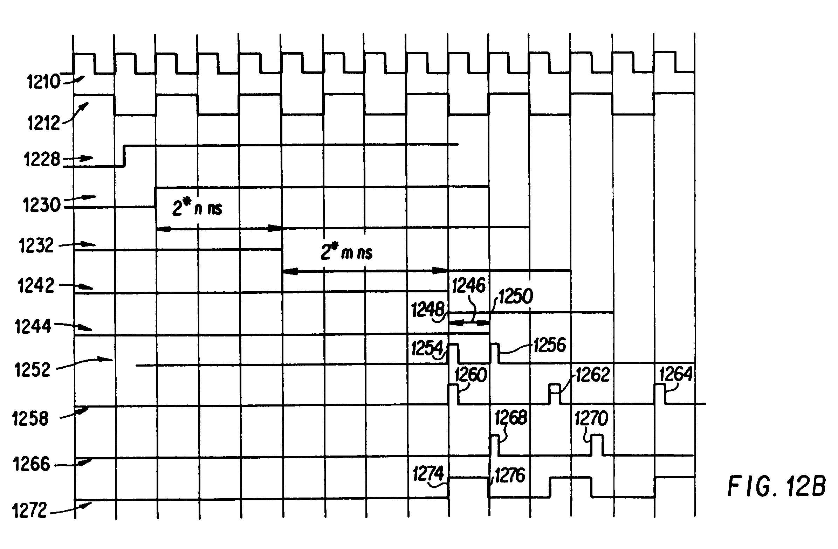

Figures 12A and 12B are timing diagrams showing exemplary waveforms of the described system 400. System operation will be described with reference to the 480 MHz VCO output clock signal from phase-locked loop 440, **which may be controllably time-shifted relative to the 240 MHz fixed pulse-repetition frequency of the UV output pulse train from laser subsystem 404.** That is, the 480 MHz clock signal 1210 (Figures 12A and 12B) supplied on output line 918 (Figures 4 and 9) is varied in time relative to the output from reference oscillator 408 (Figure 4), while the UV laser pulse train from laser subsystem 404 is fixed with respect to the output from reference oscillator 408 (Figure 4).

Waveform 1212 depicts the 480/2 MHz signal supplied at the output of divide-by-two circuit 914. Waveforms 1214, 1216 and 1218 respectively depict the 240 MHz repetition-rate UV laser pulses from laser subsystem 404 in sync, leading by 90°, and lagging by 90°, relative to waveform 1212. Again, it is to be noted that it is actually waveforms 1210 and 1212 which are shifted, while waveform 1214 remains fixed. Line 1220 of Figure 12A shows the timing of a train of laser/electron-beam pulses relative to the 480/2 MHz waveform 1212: when waveform 1212 is in sync with the laser/e-beam pulse train, the laser/e-beam pulse train is as shown by the dark lines (see arrow 1222); when waveform 1212 lags the laser/e-beam pulse train by 90°, the laser/e-beam pulse train is shifted as shown by arrow 1224; and when waveform 1212 leads the laser/e-beam pulse train by 90°, the laser/e-beam pulse train is shifted as shown by arrow 1226. Otherwise stated, fine-delay phase-locked loop 440 allows clock signal 1212 to be controllably phase-shifted in vernier fashion over a range of ± 180° relative to the UV laser pulse train. The vernier-shift "window" is approximately 2 ns as shown at line 1220 in Figure 12A (1 / 480 MHz ≈ 2.08 ns).

An operating cycle of system 400 begins with an asynchronous enable ("start") signal (Figure 12A, line 1228) supplied by data processing system 418 to AND gate 920 while restart line 1012 is high. The output of AND gate 920 is synchronized to clock signal 1212 by flip-flop 922, producing the sync enable signal (Figure 12A, line 1230). The sync enable delayed signal (Figure 12A, line 1232) on output line 942 of coarse delay counter 442 goes high at some integer number "n" of 480 MHz clock cycles after the sync enable signal (Figure 12A, line 1230) goes high; the integer number is determined by the terminal count value loaded in coarse delay counter 442.

Hold-off counter 924 is programmed to count any integer number "y" of 120 MHz clock cycles, so that its output waveform 1234 goes high at a programmable interval of approximately 8*y ns (more precisely, 1/120 MHz ≈ 8.33 ) following the first rising edge of the 120 MHz clock signal after the sync enable delayed signal 1232 goes high. Beam unblank adjustable delay circuit 926 adds a further, programmable, vernier delay of "x" ns, as depicted by the waveform of line 1236. A beam unblank pulse of 3 ns width (Figure 12A, line 1238) is produced by pulse picker 414 in response to signal 1236, to allow a single electron-beam pulse to pass through blanker 428 and into electron-beam column 426.

To summarize, Figure 12A illustrates how a single "sync enable" event (line 1230) and a single beam-unblank pulse (line 1238) are generated at programmably-controllable times relative to the 240 MHz laser/e-beam pulse train.

Waveforms 1210, 1212, 1228, 1230 and 1232 of Figure 12A are repeated in Figure 12B for reference. Waveform 1232, sync enable delayed, depicts the output signal from coarse timebase delay counter 442 (on output line 942 of Figure 9), which goes high approximately 2*n ns after sync enable waveform 1230 goes high; "n" is a terminal-count integer loaded into coarse delay counter 442 by data processing system 418.

Waveform 1242 depicts the output of an exemplary one of the 20 output lines of register/mux 1024, which goes high approximately 2*m ns after waveform 1232 goes high (more precisely, m/480MHz ≈ 2,08*m ns); "m" is a terminal-count integer loaded into counter/generator 1010 by data processing system 418. Waveform 1244 is the output of the corresponding one of the 20 vernier circuits 1028, with the rising edge delayed relative to that of waveform 1242 by a programmable interval of up to one 480 MHz clock cycle ( ≈ 2.08 ns) as shown by arrow 1246. That is, the edge can go high at any time between time 1248 and 1250. Waveform 1252 shows the narrow pulse output from the corresponding one of the 20 edge-to-pulse generators 1032; if waveform 1244 went high at time 1248, then a narrow pulse 1254 is produced, and if waveform 1244 went high at time 1250, then a narrow pulse 1256 is produced.

Waveform 1258 depicts the typical output signal from a "set" array of OR gates (*e.g.,* OR gate array 1118 of Figure 11), comprising a series of pulses 1260, 1262, 1264, etc. It is noted that, due to the programmable nature of vernier circuits 1028, the pulses may be placed as desired relative to the 480 MHz VCO clock waveform 1210. Waveform 1266 depicts the typical output signal from a "reset" array of OR gates (*e.g.,* OR gate array 1124 of Figure 11), comprising a series of pulses 1268, 1270, etc. Again, due to the programmable nature of vernier circuits 1028, the pulses may be placed as desired relative to the 480 VCO clock waveform 1210. Waveform 1272 depicts the typical output signal from S/R flip-flip 1120 on output line 1126 (Figure 11), as derived from waveforms 1258 and 1266. That is, "set" pulse 1260 causes line 1126 to go high as indicated at 1274, "reset" pulse 1268 causes line 1126 to go low at time 1276, etc.

To recap, laser subsystem 404 applies a UV output pulse train at a **fixed** pulse-repetition frequency of 240 MHz to photocathode assembly 430. The resultant electron beam sampling pulse train emitted by photocathode assembly 430 is then formed at 240 MHz, or is blanked by blanker 428 to form an integral submultiple of this frequency (*e.g.,* 120 MHz, 80 MHz, 60 MHz, *etc.*). Unblanking of blanker 428 is known as "pulse picking". Pulse picking is used where the time sweep of the sampled measurement exceeds one laser pulse repetition period.

Figures 12A and 12B illustrate exemplary waveforms of one sampling measurement cycle, *i.e.,* of one electron-beam probe pulse. Sampling measurements in accordance with the present invention are performed by varying the phase of the entire test program timing (*e.g.,* shifting the phase of the test pattern applied to the DUT) relative to the fixed electron-beam sampling pulse train. This is in contrast to the prior-art technique of fixing the test pattern timing and varying the phase of the measurement sampling pulse.

The 120 MHz signal output from reference oscillator 408 (preferably a crystal oscillator) acts as a master clock to drive the "shutter" of the laser subsystem to produce the pulsed UV laser beam, and is also used to phase lock the 480 MHz voltage-controlled oscillator 910, which may be crystal-controlled if necessary for adequate stability. Phase discriminator 902 (*e.g.,* Analog Devices part number AD9901) runs at 120MHz, and has good linearity. A programmable offset introduced by phase-locked loop 440 forces a phase shift of up to ± 45° at 120 MHz (one cycle at 480MHz, or ≈ 2.08ns) in the clock signal which drives coarse delay counter 442 and test pattern generator 416. Coarse-delay counter 442 is programmable to delay the start of the test pattern sequence by any desired number of 480 MHz clock cycles. The programmable, supplemental (fine) delay introduced by phase-locked loop 440 allows control to ≈ 1 ps resolution.

To effect time-base autocalibration, a GaAs D-type flip-flop 938 (*e.g.,* Gigabit Logic part number 10G021A) is used to detect coincidence between the shifted 480 MHz clock signal on line 918 (Figure 9) and the 120MHz reference signal from oscillator 408, to determine the ± 45° points. Non-linearity of 1% in the vernier phase shifter (fine-delay phase-locked loop 440) can cause up to 20 ps timebase error between vernier end points. This non-linearity can be characterized by, and a correction look up table created in, data processing system 418. Alternatively, a voltage-controlled phase shifter could be put in the 120 MHz signal path from reference oscillator to phase comparator 902.

It is expected that the phase-lock scheme should provide sufficiently low jitter. There is a trade off between jitter and the speed with which the phase changing can be done. Every ≈ 2.08 ns along the time base, the phase of the 480 MHz oscillator has to change 360°. With a voltage controlled crystal oscillator this could take many ms. Also, even the phase changes for the timebase steps within the vernier range could take up to 1 ms to stabilize. Good jitter performance might be obtained with a non-crystal VCO but, if performance is to be improved, a crystal VCO may be used.

In general, the use of GaAs devices is avoided as far as possible in positions where there are duty cycle variations, as this technology is known to suffer from pattern-dependent propagation delays which could cause calibration errors. However GaAs devices are preferred for use as pin drivers 448. Simulations of GaAs driver circuits have shown that rise/fall times of 80 ps can be obtained, switching 20 mA into 50 ohms. However, packaging appears to be critical. It is preferred to use a GaAs integrated circuit or discrete components on an alumina substrate. The hybrid may be either leadless with all connections done by a Tektronix Hypcon elastomer connector to a printed circuit board or an SMA-type connector could contact the fast output directly on the hybrid.

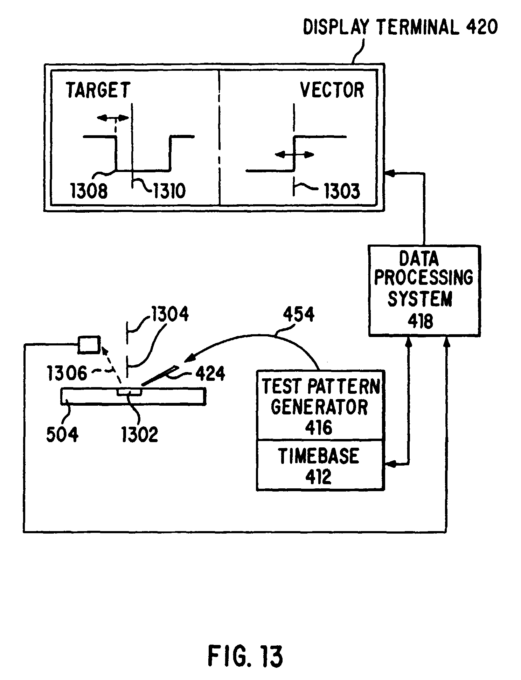

Figure 13 is a simplified illustration of how the present invention may be employed in analyzing an electronic circuit. A test-vector pattern is applied by generator 416 to a target element 1302 of a wafer 504. The test vector pattern is synchronized to a timing reference 1303, as depicted in the "vector" window of display terminal 420. Electron beam pulses 1304 are applied to target element 1302, and secondary electrons 1306 are detected to supply a probe signal to data processing system 418. An event of probe signal (such as an edge 1308) may be related to a timing reference 1310, as shown in the "target" window of display terminal 420. The probe signal event may be aligned with the timing reference by adjusting the test vector pattern relative to timing reference 1303. Such adjustment may, for example, be made by displaying the signals as illustrated, and then giving commands to the data processing system 418 by keyboard or mouse pointer or the like. The electron-beam probe may be directed to element 1302 with the aid of "navigational" tools (employing CAD data, NET list data, schematic data, etc.) and the results displayed using "display" tools as described in U.S. Patent 4,706,019 and/or as embodied in the IDS 5000™ electron beam test probe system.

The foregoing description of preferred embodiments of the invention is intended as illustrative only, and not as a limitation of the invention as defined by the claims which follow.

As used herein, an "electronic circuit" is intended to mean an integrated circuit, a hybrid circuit, an opto-electronic circuit, a multi-chip carrier module (MCM), or any other manufactured item having active and/or inactive elements and/or conductors which may be probed with an electron-beam test probe.

## Claims

1. An electron-beam test probe system for analyzing an electronic circuit (504), the analysis including the measurement of the potential at selected points on the electronic circuit, the electron-beam test probe system comprising:
a. a test probe (402) having
i. a photocathode (804) for generating a train of electron beam pulses (1220) in response to a train of laser beam pulses,
ii. means (426, 428) for applying electron beam pulses selected from said train of electron beam pulses to an electronic circuit, and
iii. means (528, 530) for measuring the potential at a point within the electronic circuit by detecting secondary electrons;
b. a laser subsystem (404) for generating a train of laser beam pulses having a stabilized repetition frequency (1214);
c. an optical coupler (452) for passing the train of laser beam pulses to the photocathode to generate the train of electron beam pulses;
d. a test pattern generator (416) responsive to a timebase circuit (412) for generating a formatted test pattern (1272) which is synchronized to the stabilized repetition frequency;
e. transmission lines (454) for supplying the formatted test pattern to the electronic circuit to be analyzed; and
f. a timebase circuit (412) synchronized with the laser subsystem and coupled to the test pattern generator (416) for inserting between a laser beam pulse of said train of laser beam pulses and the formatted test pattern a programmable delay,
characterized in that the length of the formatted test pattern and the length of the programmable delay are greater than one period of the stabilized repetition frequency and in that the timebase circuit (412) comprises:
i. a phase-locked voltage-controlled oscillator (910) synchronized with the laser subsystem (404), the oscillator supplying to the test pattern generator a reference clock signal (1210) having its phase dependent on a reference voltage supplied to the oscillator;
ii. means (906, 904) for supplying a programmable reference voltage to the oscillator to effect control of the phase of the reference clock signal; and
iii. a programmable counter (442) to count cycles of the reference clock signal supplied to the test pattern generator, said programmable counter providing a synchronization signal (1232) to said test pattern generator (416).

2. The electron-beam test probe system of claim 1, wherein the means (426) for applying electron beam pulses includes means (616) for scanning the electron beam pulses over a region of the electronic circuit, and wherein the system further comprises means (418, 420) responsive to the potential measuring means for generating an image of potentials on surfaces within the electronic circuit.

3. The electron-beam test probe system of claim 1, wherein the train of electron beam pulses has a pulse repetition rate equal to the stabilized repetition frequency, wherein the test probe comprises a controllable blanker (428) for gating the electron beam pulses, and wherein the system further comprises a pulse picker circuit (414) for controlling the blanker to reduce the electron beam pulse repetition rate to a sub-multiple of the stabilized repetition frequency.

4. The electron-beam test probe system of claim 1, wherein the laser subsystem (404) comprises:
i. a mode-locked IR, infra-red, laser (702);
ii. a first frequency-doubler (728) to convert light from the IR laser (702) to green light; and
in. a second frequency-doubler (734) to convert the green light from the first frequency-doubler (728) to UV, ultra-violet, light.

5. The electron-beam test probe system of claim 4, further comprising an electronic phase stabilizer (410) coupled to the laser subsystem (404) for reducing phase noise of the train of laser beam pulses.

6. The electron-beam test probe system of claim 1, wherein the optical coupler comprises an optical conduit (452) and a quartz lens (802) for focusing the laser beam pulses on the photocathode (804).

7. The electron-beam test probe system of claim 6, wherein the optical coupler (452) comprises an optical fiber instead of the optical conduit and a lens (742) for coupling the laser beam pulses into the optical fiber.

8. The electron-beam test probe system of claim 6, wherein the optical conduit (452) comprises a light pipe providing substantially free movement in multiple axes between the laser subsystem (404) and the photocathode, the light pipe comprising an articulated tube having joints fitted with mirrors.

9. The electron-beam test probe system of claim 1, wherein the photocathode (804) comprises:
a polished quartz substrate;
a layer of calcium fluoride deposited on a face of said polished quartz substrate; and
a gold film deposited on said layer of calcium fluoride.

10. The electron-beam test probe system of claim 9, wherein the means (426) for applying electron beam pulses comprises an evacuated electron beam column (426) having an end (812) with an opening for receiving the photocathode (804), the photocathode being received in said opening, and means (816, 818, 820, 822, 824, 826, 828) for hermetically sealing the junction between the photocathode (804) and the column end (812).

11. The electron-beam test probe system of claim 1, further comprising means (832, 834, 826) for maintaining the photocathode (804) at a high negative potential relative to ground.

12. The electron-beam test probe system of claim 11, wherein the means (46) for applying electron beam pulses comprises an anode (806) maintained at a high positive potential relative to ground.

13. The electron-beam test probe system of claim 1 wherein the test pattern generator (416) comprises:
i. a circuit (444) responsive to a synchronizing signal (1232) from the timebase circuit (412) for generating a set of timing event signals having timing events in controlled timing relationships to a start signal (1228) and to a reference clock signal (1210) and to one another;
ii. a logic array (1114, 1118, 1124) for selectively transforming at least some of the timing event signals into a pattern of "set" and "reset" signals;
iii. at least one circuit (1120) for forming the formatted test pattern from the pattern of "set" and "reset" signals; and
iv. means (1128) for driving the electronic circuit to be analyzed with the formatted test pattern.

14. The electron-beam test probe system of claim 13, wherein the circuit (444) for generating a set of timing event signals having timing events in controlled timing relationships to one another includes programmable vernier delay elements (1028) for controlling said timing relationships.

15. The electron-beam test probe system of claim 1, wherein the transmission lines (454) comprise at least one controlled impedance transmission line and at least one high-bandwidth, co-planar transmission line probe (424).

16. The electron-beam test probe system of claim 1, wherein the means for measuring the potential comprises:
i. means (530, 528) for detecting and analyzing the energy of secondary electrons and for providing a corresponding measurement signal; and
ii. a data processing system (418, 420) connected to receive, to process and to graphically display the measurement signal.

17. The electron-beam test probe system of claim 16, wherein the means for measuring the potential further comprises means (616) for aiming the electron beam pulses at a selected point within said electronic circuit with reference to design data of said electronic circuit.

18. The electron-beam test probe system of claim 9, wherein said quartz substrate is movable so that the train of laser beam pulses may be selectively applied to any point within a region of the photocathode so as to renew the photocathode.

19. The electron-beam test probe system of claim 10, further comprising means (830) for positioning the quartz substrate so that the laser beam pulses may be selectively applied to any point within a region of the photocathode so as to renew the photocathode, and wherein said means (816-828) for hermetically sealing is adapted to permit such movement without loss of hermetic seal.

20. The electron-beam test probe system of claim 4, wherein the second frequency-doubler (734) is mounted on the photocathode assembly (430) and is coupled to receive green laser light from the first frequency-doubler (728) by a flexible optical coupler.

21. The electron-beam test probe system of claim 4, wherein the first frequency-doubler (728) and the second frequency-doubler (734) are mounted on the photocathode assembly (430) and the first frequency-doubler (728) is coupled to receive infrared laser light from the mode-locked IR laser by a flexible optical coupler.

## Patentansprüche

1. Ein Elektronenstrahltestsondensystem für das Analysieren eines elektronischen Schaltkreises (504), welche Analyse die Messung des Potentials an ausgewählten Punkten des elektronischen Schaltkreises umfaßt, welches Elektronenstrahltestsondensystem umfaßt:
a. eine Testsonde (402) mit
i. einer Photokatode (804) für das Erzeugen eines Zuges von Elektronenstrahlimpulsen (1220) in Reaktion auf einen Zug von Laserstrahlimpulsen;
ii. Mittel (426, 428) für das Einwirkenlassen von Elektronenstrahlimpulsen, ausgewählt aus dem Zug von Elektronenstrahl impulsen auf einen elektronischen Schaltkreis, und
iii. Mittel (528, 530) für das Messen des Potentials an einem Punkt innerhalb des elektronischen Schaltkreises durch Erfassen von Sekundärelektronen;
b. ein Laseruntersystem (404) für das Erzeugen eines Zuges von Laserstrahlimpulsen mit einer stabilisierten Wiederholungsfrequenz (1214);
c. einen optischen Koppler (452) für das Führen des Zuges von Laserstrahlimpulsen zu der Photokatode zur Erzeugung des Zuges von Elektronenstrahlimpulsen;
d. einen Testmustergenerator (416), der auf einen Zeitbasisschaltkreis (412) reagiert für das Erzeugen eines formatierten Testmusters (1272), das synchronisiert ist auf die stabilisierte Wiederholungsfrequenz;
e. Übertragungsleitungen (454) für das Zuführen des formatierten Testmusters zu dem zu analysierenden elektronischen Schaltkreis; und
f. einen Zeitbasisschaltkreis (412), synchronisiert mit dem Laseruntersystem und angekoppelt an den Testmustergenerator (416) für das Einfügen einer programmierbaren Verzögerung zwischen einen Laserstrahlimpuls des Zuges von Laserstrahlimpulsen und das formatierte Testmuster,
dadurch gekennzeichnet, daß die Länge des formatierten Testmusters und die Länge der programmierbaren Verzögerung größer sind als eine Periode der stabilisierten Wiederholungsfrequenz und daß der Zeitbasisschaltkreis (412) umfaßt:
i. einen phasenverriegelten spannungsgesteuerten Oszillator (910), synchronisiert mit dem Laseruntersystem (404), welcher Oszillator dem Testmustergenerator ein Referenztaktsignal (1210) zuführt, dessen Phase abhängt von einer Referenzspannung, die dem Oszillator zugeführt wird;
ii. Mittel (906, 904) für das Liefern einer programmierbaren Referenzspannung an den Oszillator zum Bewirken der Steuerung der Phase des Referenztaktsignals; und
iii. einen programmierbaren Zähler (442) zum Zählen von Zyklen des Referenztaktsignals, zugeführt dem Testmustergenerator, welcher programmierbare Zähler ein Synchronisationssignal (1232) an den Testmustergenerator (416) liefert.

2. Das Elektronenstrahltestsondensystem nach Anspruch 1, bei dem die Mittel (426) für das Anlegen von Elektronenstrahlimpulsen Mittel (616) umfassen für das Abtastenlassen der Elektronenstrahlimpulse über einen Bereich des elektronischen Schaltkreises, und bei dem das System ferner Mittel (418, 420) umfaßt, die auf die Potentialmeßmittel reagieren für das Erzeugen einer Abbildung von Potentialen auf Oberflächen innerhalb des elektronischen Schaltkreises.

3. Das Elektronenstrahltestsondensystem nach Anspruch 1, bei dem der Zug von Elektronenstrahlimpulsen eine Impulswiederholungsrate aufweist gleich der stabilisierten Wiederholungsfrequenz, wobei die Testsonde einen steuerbaren Unterdrücker (428) für das Gattern der Elektronenstrahlimpulse umfaßt, und wobei das System ferner einen Pulsauswählschaltkreis (414) umfaßt für das Steuern des Unterdrückers zum Verringern der Elektronenstrahlimpulswiederholungsrate auf einen Bruchteil der stabilisierten Wiederholungsfrequenz.

4. Das Elektronenstrahltestsondensystem nach Anspruch 1, bei dem das Laseruntersystem (404) umfaßt:
i. einen modus-verriegelten IR-Infrarot-Laser (702);
ii. einen ersten Frequenzverdoppler (728) zum Umsetzen von Licht von dem IR-Laser (702) in grünes Licht; und
iii. einen zweiten Frequenzverdoppler (734) zum Umsetzen des grünen Lichts von dem ersten Frequenzverdoppler (728) in UV (ultra-violettes) Licht.

5. Das Elektronenstrahltestsondensystem nach Anspruch 4, ferner umfassend einen elektronischen Phasenstabilisator (410), angekoppelt an das Laseruntersystem (404) für das Verringern von Phasenrauschen des Zuges von Laserstrahlimpulsen.

6. Das Elektronenstrahltestsondensystem nach Anspruch 1, bei dem der optische Koppler eine optische Leitung (452) und eine Quarzlinse (802) für das Fokussieren der Laserstrahlimpulse auf die Photokatode (804) umfaßt.

7. Das Elektronenstrahltestsondensystem nach Anspruch 6, bei dem der optische Koppler (452) eine optische Faser anstelle der optischen Leitung und eine Linse (742) für das Koppeln der Laserstrahlimpulse in die optische Faser umfaßt.

8. Das Elektronenstrahltestsondensystem nach Anspruch 6, bei dem die optische Leitung (452) ein Lichtrohr umfaßt, das im wesentlichen freie Bewegung in mehreren Achsen zwischen dem Laseruntersystem (404) und der Photokatode ermöglicht, wobei das Lichtrohr ein gelenkiges Rohr mit mit Spiegeln versehenen Gelenken umfaßt.

9. Das Elektronenstrahltestsondensystem nach Anspruch 1, bei dem die Photokatode (804) umfaßt:
ein poliertes Quarzsubstrat;
eine Schicht aus Calciumfluorid, aufgebracht auf einer Seite des polierten Quarzsubstrats; und
einen Goldfilm, der auf der Schicht aus Calciumfluorid aufgebracht ist.

10. Das Elektronenstrahltestsondensystem nach Anspruch 9, bei dem die Mittel (426) für das Anlegen von Elektronenstrahlimpulsen eine evakuierte Elektronenstrahlsäule (426) umfassen mit einem Ende (812) mit einer öffnung für die Aufnahme der Photokatode (804), welche Photokatode in der öffnung aufgenommen ist, und mit Mitteln (816, 818, 820, 822, 824, 826, 828) für die hermetische Abdichtung der Stoßstelle zwischen der Photokatode (804) und dem Säulenende (812).

11. Das Elektronenstrahltestsondensystem nach Anspruch 1, ferner umfassend Mittel (832, 834, 826) für das Halten der Photokatode (804) auf einem hohen negativen Potential relativ zur Masse.

12. Das Elektronenstrahltestsondensystem nach Anspruch 11, bei dem die Mittel (426) für das Anlegen von Elektronenstrahlimpulsen eine Anode (806) umfassen, die auf hohem positivem Potential relativ zur Masse gehalten ist.

13. Das Elektronenstrahltestsondensystem nach Anspruch 1, bei dem der Testmustergenerator (416) umfaßt:
i. eine Schaltung (444), die auf ein Synchronisiersignal (1232) von dem Zeitbasisschaltkreis (412) reagiert für das Erzeugen eines Satzes von Zeitlageereignissignalen mit Zeitlageereignissen in gesteuerter zeitlicher Beziehung zu einem Startsignal (1228) und einem Referenztaktsignal (1210) und zueinander;
ii. eine Logikmatrix (1114, 1118, 1124) für selektives Transformieren mindestens einiger der Zeitlageereignissignale in ein Muster von "Setz"- und "Rücksetz"signalen;
iii. mindestens einen Schaltkreis (1120) für das Bilden des formatierten Testmusters aus dem Muster von "Setz-" und "Rücksetz"signalen; und
iv. Mittel (1128) für das Ansteuern der elektronischen zu analysierenden Schaltung mit dem formatierten Testmuster.

14. Das Elektronenstrahltestsondensystem nach Anspruch 13, bei dem die Schaltung (444) für das Erzeugen eines Satzes von Zeitlageereignissignalen mit Zeitlageereignissen in gesteuerter zeitlicher Beziehung zueinander programmierbare Vernier-Verzögerungselemente (1028) für die Steuerung der zeitlichen Beziehungen umfaßt.

15. Das Elektronenstrahltestsondensystem nach Anspruch 1, bei dem die Übertragungsleitungen (454) mindestens eine Übertragungsleitung mit gesteuerter Impedanz und mindestens eine coplanare Übertragungsleitungssonde (424) mit hoher Bandbreite umfaßt.

16. Das Elektronenstrahltestsondensystem nach Anspruch 1, bei dem die Mittel für das Messen des Potentials umfassen:
i. Mittel (530, 528) für das Erfassen und Analysieren der Energie von Sekundärelektronen und für das Erzeugen eines entsprechenden Meßsignals; und
ii. ein Datenverarbeitungssystem (418, 420), angeschlossen zum Empfangen, Verarbeiten und graphisch Wiedergeben des Meßsignals.

17. Das Elektronenstrahltestsondensystem nach Anspruch 16, bei dem die Mittel für das Messen des Potentials ferner Mittel (616) umfassen für das Richten der Elektronenstrahlimpulse auf einen ausgewählten Punkt innerhalb des elektronischen Schaltkreises unter Bezugnahme auf Konstruktionsdaten des elektronischen Schaltkreises.

18. Das Elektronenstrahltestsondensystem nach Anspruch 9, bei dem das Quarzsubstrat beweglich ist, so daß der Zug von Laserstrahlimpulsen selektiv auf irgend einen Punkt einwirken kann innerhalb eines Bereichs der Photokatode, um so die Photokatode zu erneuern.

19. Das Elektronenstrahltestsondensystem nach Anspruch 10, ferner umfassend Mittel (830) für das Positionieren des Quarzsubstrats derart, daß der Laserstrahlimpuls selektiv einwirken kann auf irgend einen Punkt innerhalb eines Bereichs der Photokatode, um so die Photokatode zu erneuern, und bei dem die Mittel (816-828) für das hermetische Abdichten ausgebildet sind, um eine solche Bewegung ohne Verlust an hermetischer Abdichtung zu ermöglichen.

20. Das Elektronenstrahltestsondensystem nach Anspruch 4, bei dem der zweite Frequenzverdoppler (734) auf der Photokatodenbaugruppe (430) montiert ist und gekoppelt ist zum Empfang von grünem Laserlicht von dem ersten Frequenzverdoppler (728) über einen flexiblen optischen Koppler.

21. Das Elektronenstrahltestsondensystem nach Anspruch 4, bei dem der erste Frequenzverdoppler (728) und der zweite Frequenzverdoppler (734) auf der Photokatodenbaugruppe (430) montiert sind, und der erste Frequenzverdoppler (728) angekoppelt ist zum Empfang von infrarotem Laserlicht von dem modusverriegelten IR-Laser über einen flexiblen optischen Koppler.

## Revendications

1. Système de sonde de mesure à faisceau d'électrons pour analyser un circuit électronique (504), l'analyse comportant la mesure du potentiel en des points sélectionnés sur le circuit électronique, le système de sonde de mesure à faisceau d'électrons comprenant:
a. une sonde de mesure (402) ayant
i. une photocathode (804) pour générer un train d'impulsions de faisceau d'électrons (1220) en réponse à un train d'impulsions de faisceau laser,
ii. un moyen (426, 428) pour appliquer des impulsions de faisceau d'électrons sélectionnées parmi ledit train d'impulsions de faisceau d'électrons, à un circuit électronique, et
iii. un moyen (528, 530) pour mesurer le potentiel en un point du circuit électronique par détection d'électrons secondaires;
b. un sous-système à laser (404) pour générer un train d'impulsions de faisceau laser ayant une fréquence de répétition stabilisée (1214);
c. un coupleur optique (452) pour transmettre le train d'impulsions de faisceau laser à la photocathode afin de générer le train d'impulsions de faisceau d'électrons;
d. un générateur de motif de contrôle (416) sensible à un circuit de base de temps (412) pour générer un motif de contrôle formaté (1272) qui est synchronisé sur la fréquence de répétition stabilisée;
e. des lignes de transmission (454) pour fournir le motif de contrôle formaté au circuit électronique à analyser; et
f. un circuit de base de temps (412) synchronisé avec le sous-système à laser et couplé au générateur de motif de contrôle (416) pour insérer entre une impulsion de faisceau laser dudit train d'impulsions de faisceau laser et le motif de contrôle formaté, un retard programmable,
caractérisé en ce que la longueur du motif de contrôle formaté et la longueur du retard programmable sont supérieures à une période de la fréquence de répétition stabilisée, et en ce que le circuit de base de temps (412) comprend:
i. un oscillateur commandé en tension verrouillé en phase (910) synchronisé avec le sous-système à laser (404), l'oscillateur fournissant au générateur de motif de contrôle un signal d'horloge de référence (1210) dont la phase dépend de la tension de référence fournie à l'oscillateur;
ii. un moyen (906, 904) pour fournir une tension de référence programmable à l'oscillateur afin qu'il effectue une commande de la phase du signal d'horloge de référence; et
iii. un compteur programmable (442) servant à compter les cycles du signal d'horloge de référence fourni au générateur de motif de contrôle, ledit compteur programmable fournissant un signal de synchronisation (1232) audit générateur de motif de contrôle (416).

2. Système de sonde de mesure à faisceau d'électrons selon la revendication 1, dans lequel le moyen (426) servant à appliquer des impulsions de faisceau d'électrons comporte un moyen (616) pour produire le balayage des impulsions de faisceau d'électrons sur une région du circuit électronique, et dans lequel le système comprend en outre un moyen (418, 420) sensible au moyen de mesure de potentiel pour générer une image de potentiels sur des surfaces situées à l'intérieur du circuit électronique.

3. Système de sonde de mesure à faisceau d'électrons selon la revendication 1, dans lequel le train d'impulsions de faisceau d'électrons a une cadence de répétition d'impulsions égale à la fréquence de répétition stabilisée, dans lequel la sonde de mesure comprend un suppresseur commandable (428) pour bloquer-débloquer le passage d'impulsions de faisceau d'électrons, et dans lequel le système comprend en outre un circuit de prélèvement d'impulsions (414 ) pour commander le suppresseur afin qu'il réduise la cadence de répétition d'impulsions du faisceau d'électrons à un sous-multiple de la fréquence de répétition stabilisée.

4. Système de sonde de mesure à faisceau d'électrons selon la revendication 1, dans lequel le sous-système à laser (404) comprend:
i. un laser infra-rouge IR à verrouillage de mode (702);
ii. un premier doubleur de fréquence (728) pour convertir la lumière provenant du laser IR (702) en lumière verte; et
iii.un second doubleur de fréquence (734) pour convertir la lumière verte provenant du premier doubleur de fréquence (728) en lumière ultraviolette (UV).

5. Système de sonde de mesure à faisceau d'électrons selon la revendication 4, comprenant en outre un stabilisateur de phase électronique (410) couplé au sous-système à laser (404) pour réduire le bruit de phase du train d'impulsions de faisceau laser.

6. Système de sonde de mesure à faisceau d'électrons selon la revendication 1, dans lequel le coupleur optique comprend un conduit optique (452) et une lentille de quartz (802) pour focaliser les impulsions de faisceau laser sur la photocathode (804).

7. Système de sonde de mesure à faisceau d'électrons selon la revendication 6, dans lequel le coupleur optique (452) comprend une fibre optique au lieu du conduit optique, et une lentille (742) pour coupler les impulsions de faisceau laser dans la fibre optique.

8. Système de sonde de mesure à faisceau d'électrons selon la revendication 6, dans lequel le conduit optique (452) comprend une canalisation optique permettant un mouvement sensiblement libre suivant des axes multiples entre le sous-système à laser (404) et la photocathode, la canalisation optique comprenant un tube articulé ayant des articulations munies de miroirs.

9. Système de sonde de mesure à faisceau d'électrons selon la revendication 1, dans lequel la photocathode (804) comprend:
un substrat de quartz poli;
une couche de fluorure de calcium déposée sur une face dudit substrat de quartz poli; et
une pellicule d'or déposée sur ladite couche de fluorure de calcium.

10. Système de sonde de mesure à faisceau d'électrons selon la revendication 9, dans lequel le moyen (426) servant à appliquer des impulsions de faisceau d'électrons comporte une colonne (426) à faisceau d'électrons sous vide ayant une extrémité (812) munie d'une ouverture destinée à recevoir la photocathode (804), la photocathode étant reçue dans ladite ouverture, et un moyen (816,818,820,822,824,826,828) servant à fermer hermétiquement la jonction entre la photocathode (804) et l'extrémité (812) de la colonne.

11. Système de sonde de mesure à faisceau d'électrons selon la revendication 1, comprenant en outre un moyen (832,834,826) pour maintenir la photocathode (804) à un potentiel négatif élevé par rapport à la masse.

12. Système de sonde de mesure à faisceau d'électrons selon la revendication 1, dans lequel le moyen (426) servant à appliquer des impulsions de faisceau d'électrons comporte une anode (806) maintenue à un potentiel positif élevé par rapport à la masse.

13. Système de sonde de mesure à faisceau d'électrons selon la revendication 1, dans lequel le générateur (416) de motif de contrôle comprend:
i. un circuit (444) sensible à un signal de synchronisation (1232) provenant du circuit de base de temps (412) pour générer un ensemble de signaux d'événements de cadencement ayant des événements de cadencement présentant des relations temporelles commandées par rapport à un signal de déclenchement (1228) et à un signal d'horloge de référence (1210) et les uns par rapport aux autres;
ii. une matrice logique (1114, 1118, 1124) pour transformer sélectivement au moins certains des signaux d'événements de cadencement en un motif de signaux de "mise à 1" et de "remise à 0";
iii. au moins un circuit (1120) pour former le motif de contrôle formaté à partir du motif de signaux de "positionnement" et d e "réinitialisation"; et
iv. un moyen (1128) pour exciter le circuit électronique à analyser avec le motif de contrôle formaté.

14. Système de sonde de mesure à faisceau d'électrons selon la revendication 13, dans lequel le circuit (444) servant à générer un ensemble de signaux d'événements de cadencement ayant des événements de cadencement présentant des relations temporelles commandées les uns par rapport aux autres, comporte des éléments à retard démultiplié programmable (1028) pour commander lesdites relations temporelles.

15. Système de sonde de mesure à faisceau d'électrons selon la revendication 1, dans lequel les lignes de transmission (454) comprennent au moins une ligne de transmission à impédance commandée et au moins une sonde (424) de ligne de transmission coplanaire à grande largeur de bande.

16. Système de sonde de mesure à faisceau d'électrons selon la revendication 1, dans lequel le moyen servant à mesurer le potentiel comprend:
i. un moyen (530,528) pour détecter et analyser l'énergie d'électrons secondaires et pour fournir un signal de mesure correspondant; et
ii. un système de traitement de données (418,420) connecté pour recevoir, pour traiter et pour afficher graphiquement le signal de mesure.

17. Système de sonde de mesure à faisceau d'électrons selon la revendication 16, dans lequel le moyen servant à mesurer le potentiel comprend en outre un moyen (616) servant à diriger des impulsions de faisceau d'électrons vers un point sélectionné dans ledit circuit électronique par référence à des données de conception dudit circuit électronique.

18. Système de sonde de mesure à faisceau d'électrons selon la revendication 9, dans lequel ledit substrat de quartz est mobile de façon que le train d'impulsions de faisceau laser puisse être sélectivement appliqué en un point quelconque d'une région de la photocathode de façon à renouveler la photocathode.

19. Système de sonde de mesure à faisceau d'électrons selon la revendication 10, comprenant en outre un moyen (830) pour positionner le substrat de quartz de façon que les impulsions de faisceau laser puissent être appliquées sélectivement en un point quelconque d'une région de la photocathode de façon à renouveler la photocathode, et dans lequel ledit moyen (816-828) de fermeture hermétique est conçu pour permettre ce mouvement sans rupture de la fermeture hermétique.

20. Système de sonde de mesure à faisceau d'électrons selon la revendication 4, dans lequel le second doubleur de fréquence (734) est monté sur l'ensemble à photocathode (430) et est couplé de façon à recevoir une lumière laser verte du premier doubleur de fréquence (728) au moyen d'un coupleur optique souple.

21. Système de sonde de mesure à faisceau d'électrons selon la revendication 4, dans lequel le premier doubleur de fréquence (728) et le second doubleur de fréquence (734) sont montés sur l'ensemble à photocathode (430) et le premier doubleur de fréquence (728) est couplé de façon à recevoir une lumière laser infrarouge du laser IR à verrouillage de mode au moyen d'un coupleur optique souple.
